# EUROPÄISCHE PATENTSCHRIFT

(11) **EP 2 901 504 B1**
(45) Veröffentlichungstag und Bekanntmachung des Hinweises auf die Patenterteilung: **15.08.2018**
(21) Anmeldenummer: 13762093.6
(22) Anmeldetag: 09.09.2013
(51) Int. Cl.: H01L 41/047, H01L 41/293

(54) **KONTAKTIERUNG EINES ELEKTRISCHEN BAUELEMENTS UND VERFAHREN ZUR HERSTELLUNG DERSELBEN**
ELECTRICAL COMPONENT AND METHOD FOR ESTABLISHING CONTACT WITH AN ELECTRICAL COMPONENT
COMPOSANT ÉLECTRIQUE ET PROCÉDÉ D'ÉTABLISSEMENT D'UNE MISE EN CONTACT ÉLECTRIQUE D'UN COMPOSANT ÉLECTRIQUE

(30) Priorität: 28.09.2012 DE 102012109250
(43) Veröffentlichungstag der Anmeldung: 05.08.2015
(73) Patentinhaber: Epcos AG, 81671 München (DE)
(72) Erfinder: OTTLINGER, Marion, A-8530 Deutschlandsberg (AT); KRUMPHALS, Robert, A-8530 Deutschlandsberg (AT); STANI, Andreas, A-8430 Leibnitz (AT)
(74) Vertreter: Epping - Hermann - Fischer
(86) Internationale Anmeldenummer: PCT/EP2013/068633
(87) Internationale Veröffentlichungsnummer: WO 2014/048713

(56) Entgegenhaltungen:
- EP-A1- 2 267 808
- EP-A1- 2 337 103
- EP-A1- 2 437 322
- US-A1- 2008 007 144

## Beschreibung

Es wird ein elektrisches Bauelement aufweisend wenigstens eine Metallisierung angegeben. Insbesondere ist die Metallisierung zur Kontaktierung von Innenelektroden des Bauelements vorgesehen. Das elektrische Bauelement ist beispielsweise als Piezoaktor ausgebildet. Weiterhin wird ein Verfahren zur Herstellung einer Kontaktierung eines elektrischen Bauelements angegeben.

In der Druckschrift WO 2010/020643 A1 ist ein Piezoaktor beschrieben, der eine Außenkontaktierung aufweist, bei dem ein Drahtgewebe an einer Grundmetallisierung befestigt ist. In der Druckschrift EP 0844678 B1 ist ein Piezoaktor angegeben, der eine dreidimensional strukturierte, elektrisch leitende Elektrode aufweist, die über partielle Kontaktstellen mit einer Grundmetallisierung verbunden ist. Aus der Druckschrift EP 2 437 322 A1 ist ein piezoelektrisches Bauelement mit einer zweischichtigen eingebrannten Außenelektrode bekannt, wobei die obere Schicht die untere nur teilweise bedeckt. Ein ähnliches Bauelement offenbart US 2008/007144 A1, wobei die obere Schicht entweder zwei Streifen oder einen rechteckigen Rahmen umfasst und auf dieser etwa ein leitendes Gitter angebracht ist. Es ist eine zu lösende Aufgabe, ein verbessertes elektrisches Bauelement anzugeben. Ferner ist es eine zu lösende Aufgabe, ein Verfahren zur Herstellung eines elektrischen Bauelements anzugeben.

Es wird ein elektrisches Bauelement angegeben. Beispielsweise ist das Bauelement als Piezoaktor, insbesondere als Piezoaktor zum Betätigen eines Einspritzventils in einem Kraftfahrzeug, ausgebildet. Das Bauelement weist vorzugsweise einen Grundkörper auf. Der Grundkörper weist vorzugsweise Innenelektroden auf. Die Innenelektroden sind beispielsweise als Elektrodenschichten ausgebildet.

Das Bauelement ist als Vielschichtbauelement ausgebildet, wobei funktionale Schichten und Elektrodenschichten abwechselnd übereinander gestapelt sind. Die funktionalen Schichten sind beispielsweise piezoelektrische Schichten, insbesondere piezokeramische Schichten. Die Innenelektroden erstrecken sich vorzugsweise in Stapelrichtung abwechselnd bis zu einer Außenseite des Grundkörpers und sind von der gegenüberliegenden Außenseite beabstandet. Der Stapel aus Elektrodenschichten und funktionalen Schichten ist vorzugsweise als monolithischer Sinterkörper ausgebildet.

Das elektrische Bauelement weist wenigstens einen Außenkontakt aufweisend wenigstens eine Metallisierung auf. Der Außenkontakt ist vorzugsweise zur Kontaktierung von Innenelektroden des Grundkörpers ausgebildet. Die Metallisierung ist vorzugsweise auf einer Außenseite des Grundkörpers angeordnet. Vorzugsweise ist die Metallisierung schichtförmig ausgebildet. Die Metallisierung kontaktiert vorzugsweise jede zweite Innenelektrode. Zur Kontaktierung der weiteren Innenelektroden kann eine weitere Metallisierung vorgesehen sein, die beispielsweise auf einer gegenüberliegenden Außenseite des Grundkörpers angeordnet ist.

Gemäß einem ersten Aspekt der Erfindung weist das elektrische Bauelement einen Außenkontakt mit einer ersten Metallisierung und einer zweiten Metallisierung auf, wobei die zweite Metallisierung auf der ersten Metallisierung angeordnet ist.

Die erste Metallisierung ist vorzugsweise direkt auf einer Außenseite des Grundkörpers angeordnet und vorzugsweise in direktem elektrischen Kontakt mit Innenelektroden des Grundkörpers. Die Metallisierungen dienen vorzugsweise zur elektrischen Kontaktierung der Innenelektroden. Beide Metallisierungen sind als eingebrannte Metallisierungen ausgebildet. Die erste Metallisierung bedeckt die zweite Metallisierung nur teilweise.

Zur Herstellung einer eingebrannten Metallisierung wird beispielsweise eine metallische Paste auf eine Außenseite des Grundkörpers aufgetragen. Anschließend wird die metallische Paste, beispielsweise bei einer Temperatur im Bereich von 500°C bis 900°C eingebrannt. Erfindungsgemäß wird zur Herstellung der ersten Metallisierung eine erste metallische Paste auf eine Außenseite des Grundkörpers aufgetragen und eingebrannt. Anschließend wird zur Herstellung der zweiten Metallisierung eine zweite metallische Paste auf die erste Metallisierung aufgetragen und eingebrannt. Bei einem derartigen zweistufigen Einbrandprozess der Metallisierungen kann eine Vermischung der Materialien der Metallisierungen besonders gut verhindert werden. Insbesondere kann eine Diffusion von Materialbestandteilen von einer der Metallisierungen in die andere Metallisierung verhindert werden.

Gemäß einer Ausführungsform weisen die erste und die zweite Metallisierung eine unterschiedliche Benetzbarkeit mit Lotmaterial auf. Beispielsweise ist das Lotmaterial ein Zinn-Silber-Lot.

Durch die unterschiedliche Benetzbarkeit kann erreicht werden, dass ein Kontaktelement, das an wenigstens einer der Metallisierungen befestigt werden soll, ausreichend stark an einer der beiden Metallisierungen befestigt ist und an der anderen Metallisierung weniger gut oder nicht befestigt ist.

Somit kann ein Befestigungsbereich des Kontaktelements durch die Form der Metallisierung mit der höheren Benetzbarkeit bestimmt werden.

Vorzugsweise weist die erste Metallisierung eine geringere Benetzbarkeit mit Lotmaterial auf als die zweite Metallisierung. Beispielsweise kann zur Befestigung des Kontaktelements an der ersten Metallisierung das Kontaktelement großflächig mit Lotmaterial versehen sein und auf die Metallisierungen aufgelegt werden. Alternativ kann Lotmaterial großflächig auf die freiliegenden Flächen der Metallisierungen aufgebracht werden. Anschließend wird ein Lötvorgang durchgeführt. Aufgrund der unterschiedlichen Benetzbarkeit der Metallisierungen mit Lotmaterial haftet das Kontaktelement gut an der zweiten Metallisierung und weniger gut oder nicht an der ersten Metallisierung.

Gemäß einer Ausführungsform weist die erste Metallisierung einen Glasanteil auf und die zweite Metallisierung weist keinen Glasanteil oder einen geringeren Glasanteil als die erste Metallisierung auf.

Aufgrund des Glasanteils in der ersten Metallisierung kann eine besonders feste Verbindung der ersten Metallisierung mit dem Grundkörper, insbesondere mit keramischen Schichten des Grundkörpers erzielt werden. Durch den fehlenden oder geringeren Glasanteil der zweiten Metallisierung wird vorzugsweise die Benetzbarkeit der zweiten Metallisierung mit Lotmaterial im Vergleich zur ersten Metallisierung erhöht. Erfindungsgemäß weist die zweite Metallisierung eine kleinere Fläche auf als die erste Metallisierung.

Dabei ist mit der Fläche der jeweiligen Metallisierung vorzugsweise die Hauptfläche einer schichtförmigen Metallisierung bezeichnet. Die Hauptfläche verläuft vorzugsweise parallel zur Außenseite des Grundkörpers, auf der die Metallisierungen angeordnet sind.

Aufgrund der großen Fläche der ersten Metallisierung kann eine gute Anbindung an den Grundkörper erreicht werden. Augrund der geringeren Fläche der zweiten Metallisierung kann ein Kontaktelement in einem gewünschten, kleineren Bereich befestigt werden, so dass beispielsweise die Flexibilität des Kontaktelements durch den Befestigungsbereich nur wenig beeinträchtigt wird. Dadurch können insbesondere Risse im Grundkörper durch das Kontaktelement überbrückt werden.

Die erste Metallisierung ist beispielsweise vollflächig ausgebildet. Dies bedeutet, dass die erste Metallisierung als durchgehende Fläche ausgebildet ist und keine Aussparungen aufweist. Beispielsweise weist die zweite Metallisierung wenigstens eine Aussparung auf.

Erfindungsgemäß ist die zweite Metallisierung U-förmig ausgebildet. In diesem Fall sind zwei parallel angeordnete Teilbereiche an einem Ende der Teilbereiche durch einen dritten Teilbereich miteinander verbunden.

In einer Ausführungsform ist an wenigstens einer der Metallisierungen ein Kontaktelement befestigt. Vorzugsweise ist das Kontaktelement an der zweiten Metallisierung befestigt.

Vorzugsweise ist das Kontaktelement flexibel ausgebildet. Auf diese Weise kann das Kontaktelement bei mechanischer Belastung nachgeben ohne zu reißen. Insbesondere kann das Kontaktelement Risse, die im Grundkörper auftreten, überbrücken und so einen zuverlässigen elektrischen Anschluss des Bauelements sicherstellen. Vorzugsweise weist das Kontaktelement wenigstens eine Aussparung auf.

Das Kontaktelement kann eine Netz- oder Gewebestruktur aufweisen. Das Kontaktelement weist beispielsweise eine Vielzahl von Drähten auf. Insbesondere kann das Kontaktelement als Drahtgewebe oder Drahtnetz ausgebildet sein. Alternativ kann das Kontaktelement auch als metallisches Blech ausgebildet sein. In dem metallischen Blech können eine oder mehrere Aussparungen vorgesehen sein, beispielsweise kreisförmige Aussparungen.

Das Kontaktelement ist vorzugsweise an wenigstens einer der Metallisierungen angelötet. Vorzugsweise ist das Kontaktelement an der zweiten Metallisierung angelötet. Das Kontaktelement kann zusätzlich auch an der ersten Metallisierung angelötet sein. Im Fall, dass die erste Metallisierung eine geringe Benetzbarkeit mit Lotmaterial aufweist, ist das Kontaktelement beispielsweise nicht oder nur mit geringer Haftkraft mit der ersten Metallisierung verlötet.

Vorzugsweise ist wenigstens ein seitlicher Randbereich des Kontaktelements an der zweiten Metallisierung direkt befestigt. Insbesondere steht kein Teil des Randbereichs über die zweite Metallisierung hinaus. Auf diese Weise kann verhindert werden, dass ein unbefestigter Teil des Randbereichs zu einer Beschädigung des Bauelements führt. Beispielsweise ist bei einer rahmenförmigen zweiten Metallisierung das Kontaktelement am Rahmen befestigt und steht nicht seitlich über den Rahmen hinaus. Insbesondere kann bei einer U-förmigen zweiten Metallisierung das Kontaktelement an drei seitlichen Randbereichen an der zweiten Metallisierung befestigt sein. Vorzugsweise steht das Kontaktelement nicht über die erste Metallisierung seitlich über.

In einer Ausführungsform ist am Kontaktelement eine Weiterkontaktierung befestigt. Die Weiterkontaktierung dient vorzugsweise zum elektrischen Anschluss des Bauelements an eine Spannungsquelle. Beispielsweise weist die Weiterkontaktierung einen Draht oder eine Vielzahl von Drähten auf. Vorzugsweise ist die Weiterkontaktierung als Kontaktstift ausgebildet.

Die Weiterkontaktierung ist vorzugsweise nicht oberhalb der zweiten Metallisierung angeordnet. Mit dem Begriff "oberhalb" ist dabei die Richtung der Flächennormale von der mit der zweiten Metallisierung versehenen Außenseite des Grundkörpers bezeichnet. Insbesondere ist die Weiterkontaktierung nicht oberhalb eines Befestigungsbereichs des Kontaktelements an einer der Metallisierungen angeordnet. Auf diese Weise kann die Weiterkontaktierung besonders gut an dem Kontaktelement befestigt werden, ohne dass eine Beschädigung des Bauelements auftritt.

Beispielsweise ist die Weiterkontaktierung am Kontaktelement angeschweißt. Die Weiterkontaktierung kann beim Befestigungsschritt an das Kontaktelement angedrückt werden. Wenn das Kontaktelement in diesem Bereich nicht direkt an einer Metallisierung befestigt ist, kann das Kontaktelement beispielsweise nachgeben, wodurch ein guter Kontakt des Kontaktelements mit der Weiterkontaktierung erzielt werden kann. Weiterhin wird in diesem Fall beim Befestigungsschritt, insbesondere einem Schweiß- oder Lötvorgang, die Grundmetallisierung nicht beschädigt.

Die Weiterkontaktierung ist vorzugsweise zumindest teilweise oberhalb der ersten Metallisierung angeordnet. Beispielsweise erstreckt sich die Weiterkontaktierung bei einer U-förmigen Ausgestaltung der zweiten Metallisierung durch die Öffnung des U-förmigen Bereichs in das Innere des U-förmigen Bereichs hinein.

Gemäß einem weiteren Aspekt der Erfindung wird ein elektrisches Bauelement mit wenigstens einem Außenkontakt aufweisend wenigstens eine Metallisierung angegeben, wobei die Metallisierung rahmenförmig ausgebildet ist, wobei die Rahmenform der Metallisierung eine Öffnung aufweist, so dass die Rahmenform U-förmig ausgebildet ist.

In einer Ausführungsform ist an der rahmenförmigen Metallisierung ein Kontaktelement wie oben beschrieben befestigt. Vorzugsweise ist wenigstens ein seitlicher Randbereich des Kontaktelements am Rahmen direkt befestigt. Zudem kann eine Weiterkontaktierung, insbesondere in Form eines Kontaktstifts am Kontaktelement befestigt sein.

Gemäß einem weiteren Aspekt der Erfindung wird ein Verfahren zur Herstellung einer elektrischen Kontaktierung eines elektrischen Bauelements angegeben. Es wird ein Grundkörper eines elektrischen Bauelements bereitgestellt und eine erste metallische Paste auf einer Außenseite des Grundkörpers aufgebracht. Anschließend wird die erste metallische Paste zur Ausbildung einer ersten Metallisierung eingebrannt. Danach wird eine zweite metallische Paste auf die erste Metallisierung aufgebracht und anschließend wird die zweite metallische Paste eingebrannt. Durch das Verfahren werden die oben beschriebenen Bauelemente hergestellt, wobei die im Verfahren verwendeten Bestandteile alle funktionellen und strukturellen Eigenschaften der Bestandteile der oben beschriebenen Bauelemente aufweisen.

An wenigstens einer der Metallisierungen kann ein Kontaktelement befestigt, insbesondere angelötet werden. Dazu wird das Kontaktelement beispielsweise großzügig mit Lotmaterial beschichtet. Die erste und zweite Metallisierung können eine unterschiedliche Benetzbarkeit mit Lotmaterial aufweisen. Auf diese Weise kann erreicht werden, dass das Kontaktelement nur an einer der Metallisierungen befestigt wird und an der anderen Metallisierung nicht oder wenig gut befestigt wird. Weiterhin kann an dem Kontaktelement eine Weiterkontaktierung wie oben beschrieben befestigt werden, beispielsweise angeschweißt werden.

Im Folgenden werden die hier beschriebenen Gegenstände anhand von schematischen und nicht maßstabsgetreuen Ausführungsbeispielen näher erläutert. Es zeigen:
- Figur 1: eine Aufsicht auf ein elektrisches Bauelement,
- Figur 2: einen Querschnitt des Bauelements aus Figur 1,
- Figur 3: eine Aufsicht auf ein elektrisches Bauelement aufweisend ein Kontaktelement,
- Figuren 4A, 4B, 4C, 4D: Verfahrensschritte bei der Herstellung einer Kontaktierung eines elektrischen Bauelements,
- Figur 5: in einem Diagramm die Häufigkeit eines Abzugs von Außenkontakten in Abhängigkeit von einer ausgeübten Kraft.

Vorzugsweise verweisen in den folgenden Figuren gleiche Bezugszeichen auf funktionell oder strukturell entsprechende Teile der verschiedenen Ausführungsformen.

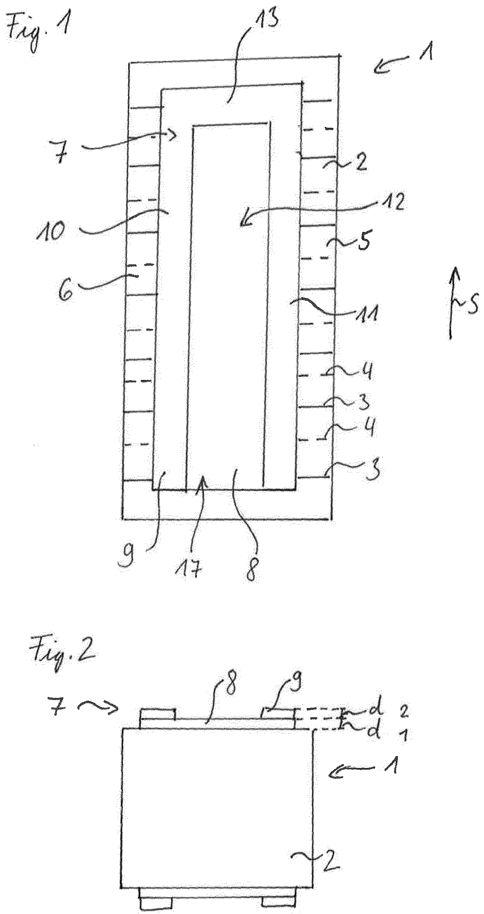

Figur 1 zeigt eine Aufsicht auf ein elektrisches Bauelement 1. Figur 2 zeigt einen Querschnitt des Bauelements aus Figur 1.

Das elektrische Bauelement 1 ist vorzugsweise ein piezoelektrisches Bauelement, insbesondere ein Piezoaktor. Das Bauelement 1 ist als Vielschichtbauelement ausgebildet.

Das Bauelement 1 weist einen Grundkörper 2 auf, in dem erste und zweite Innenelektroden 3, 4 und funktionale Schichten 5 entlang einer Stapelrichtung S abwechselnd übereinander gestapelt sind.

Die Innenelektroden 3, 4 erstrecken sich abwechselnd bis zu einer Außenseite 6 der Grundkörpers 2 und sind von einer gegenüberliegenden Außenseite (nicht abgebildet) beabstandet. Beispielsweise enthalten die Innenelektroden 3, 4 Kupfer, Silber, oder Silber-Palladium.

Die funktionalen Schichten 5 sind beispielsweise als dielektrische Schichten, insbesondere als piezoelektrische Schichten, ausgebildet. Die funktionalen Schichten 5 können aus einem keramischen Material gebildet sein, insbesondere als piezokeramische Schichten ausgebildet sein. Vorzugsweise dehnt sich das Bauelement 1 beim Anlegen einer Spannung zwischen die Innenelektroden 3, 4 aus. Die Ausdehnung erfolgt beispielsweise in Stapelrichtung S.

Zur Kontaktierung der ersten Innenelektroden 3 ist ein Außenkontakt 7 auf einer Außenseite 6 des Grundkörpers 2 angeordnet. Der Außenkontakt 7 weist eine erste Metallisierung 8 und eine zweite Metallisierung 9 auf. Die erste Metallisierung 8 ist in direktem Kontakt mit den funktionalen Schichten 5 und den ersten Innenelektroden 3. Die zweite Metallisierung 9 ist auf der ersten Metallisierung 8 angeordnet und ist in direktem Kontakt mit der ersten Metallisierung 8. Die Metallisierungen 8, 9 sind schichtförmig ausgebildet. Die zweite Metallisierung 9 bedeckt die Außenseite der ersten Metallisierung 8, auf der sie angeordnet ist, d.h. die vom Grundkörper 2 abgewandte Außenseite der ersten Metallisierung 8, nur teilweise und lässt Teilbereiche der Außenseite der ersten Metallisierung 8 unbedeckt.

Beide Metallisierungen 8, 9 sind als Einbrandmetallisierungen ausgebildet. Insbesondere sind die Metallisierungen 8, 9 durch Auftragen und Einbrennen einer metallischen Paste hergestellt. Vorzugsweise wird zuerst die erste Metallisierung 8, beispielsweise durch Siebdrucken, aufgebracht und eingebrannt. Anschließend wird die zweite Metallisierung 9, beispielsweise durch Siebdrucken, aufgebracht und eingebrannt.

Beide Metallisierungen 8, 9 enthalten ein Metall. Vorzugsweise enthält wenigstens eine der Metallisierungen 8, 9 Kupfer. Alternativ oder zusätzlich können die Metallisierungen 8, 9 Silber oder Silber-Palladium enthalten. Die Metallisierungen 8, 9 können auch unterschiedliche Metalle enthalten, Beispielsweise kann eine der Metallisierungen Kupfer und die andere Metallisierung Silber enthalten.

Die erste Metallisierung 8 enthält einen Glasanteil, insbesondere eine Glasfritte. Der Glasanteil gewährleistet vorzugsweise die Haftfestigkeit der Metallisierung 8 auf der Außenseite 6 der Grundkörpers 2, beispielsweise an einem keramischen Material des Grundkörpers 2. Vorzugsweise liegt der Glasanteil in der ersten Metallisierung 8 zwischen 3 und 10 Gewichtsprozent (Gew.-%). Beispielsweise liegt der Glasanteil bei 6 Gew.-%. Der Glasanteil in der ersten Metallisierung 8 hat zur Folge, dass die Benetzbarkeit der ersten Metallisierung 8 mit einem Lotmaterial gering ist.

Die zweite Metallisierung 9 weist keinen Glasanteil auf oder weist einen geringeren Glasanteil auf als die erste Metallisierung 8 auf. Beim Einbrennen der zweiten Metallisierung 9 kann allerdings ein geringer Glasanteil aus der ersten Metallisierung 8 in die zweite Metallisierung 9 diffundieren, so dass, auch wenn zur Herstellung der zweiten Metallisierung 9 eine Paste ohne Glasanteil verwendet wird, ein geringer Glasanteil nach dem Einbrennen in der zweiten Metallisierung 9 vorhanden sein kann. Durch ein zweistufiges Einbrennen der Metallisierungen 8, 9 kann eine derartige Diffusion ganz oder weitgehend verhindert werden. Die erste Metallisierung 8 kann eine höhere Porosität aufweisen als die zweite Metallisierung 9.

Beispielsweise besteht die zweite Metallisierung 9 aus einem Metall. Die zweite Metallisierung 9 weist aufgrund des fehlenden oder geringen Glasanteils eine gute Benetzbarkeit mit einem Lotmaterial auf.

Die erste Metallisierung 8 ist in Form einer rechteckigen Fläche ausgebildet. Insbesondere weist die erste Metallisierung 8 keine Aussparungen auf, ist also vollflächig ausgebildet.

Die zweite Metallisierung 9 weist zwei streifenförmige Teilbereiche 10, 11 auf, die parallel zueinander verlaufen. Die Teilbereiche 10, 11 verlaufen in Stapelrichtung S. Zwischen den Teilbereichen 10, 11 weist die zweite Metallisierung 9 eine Aussparung 12 auf, durch die die erste Metallisierung 8 zu sehen ist. Die zwei Teilbereiche 10, 11 sind durch einen dritten Teilbereich 13 miteinander verbunden. Der dritte Teilbereich 13 verläuft senkrecht zur Stapelrichtung S. Die zweite Metallisierung 9 ist insgesamt U-förmig ausgebildet. Insbesondere ist die zweite Metallisierung 9 rahmenförmig ausgebildet, wobei eine Öffnung 17 in der Rahmenform vorgesehen ist.

Die erste Metallisierung 8 weist in eingebranntem Zustand vorzugsweise eine Dicke d₁ (siehe Figur 2) im Bereich von 5 µm bis 30 µm auf. Beispielsweise liegt die Dicke d₁ bei 20 µm. Die zweite Metallisierung 9 weist beispielsweise eine Dicke d₂ (siehe Figur 2) im Bereich von 10 µm bis 60 µm auf. Beispielsweise liegt die Dicke d₂ bei 40 µm. Die Dicken d₁ und d₂ können auch gleich sein. Beispielsweise können beide Dicken d₁, d₂ bei 20 µm liegen.

Die Fläche der ersten Metallisierung 8 ist größer als die Fläche der zweiten Metallisierung 9. Durch die große Fläche der ersten Metallisierung 8 kann eine gute Haftfestigkeit des Außenkontakts 7 an der Außenseite 6 gewährleistet werden. Durch die kleinere Fläche der zweiten Metallisierung 9 kann ein Kontaktelement in einem kleineren Befestigungsbereich an der zweiten Metallisierung 9 befestigt werden. Durch den unterschiedlichen Grad der Benetzbarkeit der ersten und zweiten Metallisierung 8, 9 kann ein Kontaktelement auf einfache Weise nur an der zweiten Metallisierung 8 und nicht, oder nur in geringem Grad, an der ersten Metallisierung 9 befestigt werden. Dies erlaubt beispielsweise eine Befestigung des Kontaktelements nur in durch die zweite Metallisierung 9 definierten Befestigungsbereichen.

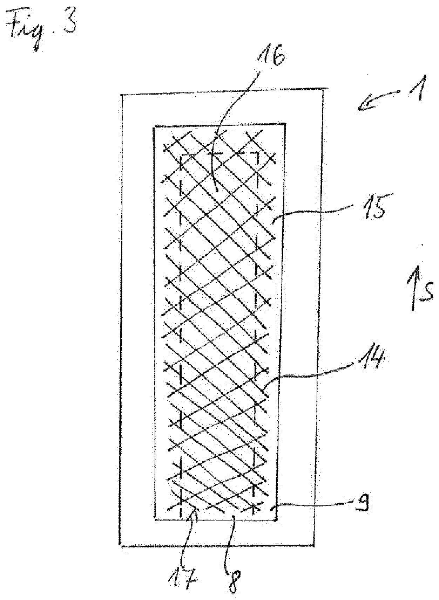

Figur 3 zeigt eine Aufsicht auf ein elektrisches Bauelement 1 mit einem Kontaktelement 14.

Das elektrische Bauelement 1 ist wie das in den Figuren 1 und 2 beschriebene Bauelement ausgebildet, wobei der Außenkontakt 7 hier zusätzlich ein Kontaktelement 14 aufweist, das auf der zweiten Metallisierung 9 angeordnet ist. Die Innenelektroden sind hier aus Gründen der Übersichtlichkeit nicht eingezeichnet. Das Kontaktelement 14 weist eine netzartige Struktur, insbesondere eine Gewebestruktur auf. Insbesondere weist das Kontaktelement 14 eine Vielzahl von miteinander verwobenen metallischen Drähten auf.

Das Kontaktelement 14 ist an der zweiten Metallisierung 9 angelötet. Durch die unterschiedliche Benetzbarkeit der ersten und zweiten Metallisierung 8, 9 mit einem Lotmaterial haftet das Lotmaterial gut an der zweiten Metallisierung 9, aber nur schlecht oder überhaupt nicht an der ersten Metallisierung 8. Somit wird ein Befestigungsbereich 15, in dem das Kontaktelement 14 mit der darunter liegenden Metallisierung 8, 9 verlötet ist, durch die Geometrie der zweiten Metallisierung 9 bestimmt. Somit kann zur Verlötung des Kontaktelements 14 im Kontaktbereich 15 ein Lotmaterial großflächig auf dem Kontaktelement 14 oder den Metallisierungen 8, 9 aufgebracht sein. Aufgrund der guten Benetzbarkeit der zweiten Metallisierung 9 wird das Kontaktelement 14 mit der zweiten Metallisierung 9 durch das Lotmaterial fest verbunden. Aufgrund der schlechten Benetzbarkeit der ersten Metallisierung 8 wird das Kontaktelement 14 nicht oder nur mit geringer Haftfestigkeit mit der ersten Metallisierung 8 verbunden. Somit kann das Kontaktelement 14 auf einfache Weise nur in einem gewünschten Befestigungsbereich 15 befestigt werden. Insbesondere kann das Kontaktelement 14 nur partiell, d.h. nur in Teilen seiner Außenfläche befestigt sein, während in einem Bereich geringer Haftfestigkeit 16 das Kontaktelement 14 nicht oder nur mit geringer Haftfestigkeit 16 mit dem Grundkörper 2 verbunden ist. Dies ermöglicht beispielsweise die elektrische Überbrückung von Rissen im Grundkörper 2, die während einer Polarisation des Bauelements 1 oder im Betrieb auftreten können. Vorzugsweise ist das Kontaktelement 14 flexibel ausgebildet, so dass es beim Auftreten von mechanischen Spannungen, die z. B. durch einen Riss im Grundkörper 2 erzeugt werden, gedehnt wird ohne zu reißen.

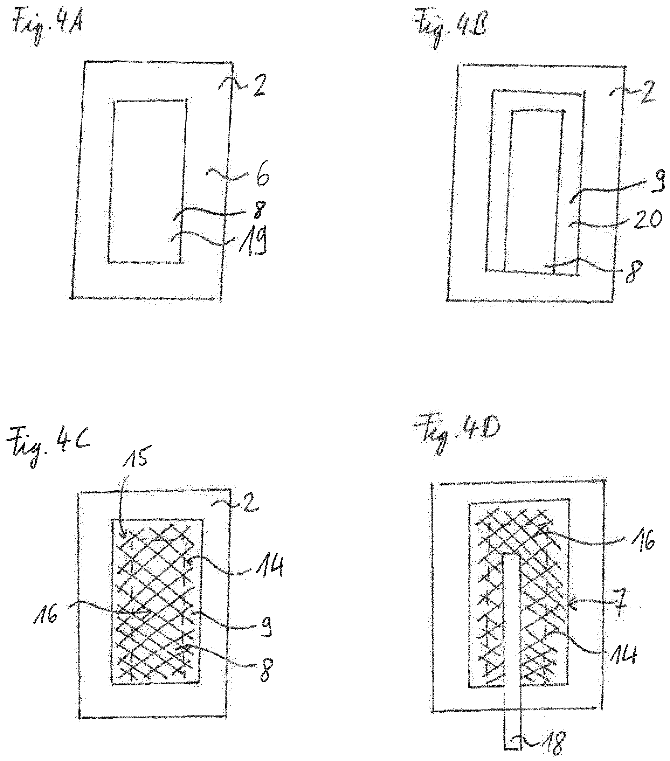

Zum elektrischen Anschluss des Außenkontakts 7 kann eine Weiterkontaktierung 18, beispielsweise ein Kontaktstift, am Außenkontakt 7 befestigt sein (siehe Figur 4D). Vorzugsweise erstreckt sich die Weiterkontaktierung 18 oberhalb der Öffnung 17 in die Rahmenform der zweiten Metallisierung 9 hinein. Vorzugsweise ist die Weiterkontaktierung 18 nicht in einen Bereich oberhalb der zweiten Metallisierung 9 angeordnet.

Die Figuren 4A, 4B, 4C und 4D zeigen Verfahrensschritte bei der Herstellung einer Kontaktierung eines elektrischen Bauelements, beispielsweise eines in den Figuren 1 bis 3 gezeigten Bauelements 1.

Gemäß Figur 4A wird ein Grundkörper 2 eines Bauelements 1 bereitgestellt. Auf eine Außenseite 6 des Grundkörpers 2 wird zur Ausbildung einer ersten Metallisierung eine erste metallische Paste 19, beispielsweise in einem Siebdruckverfahren, aufgebracht. Die erste metallische Paste 19 wird in Form eines vollflächig gefüllten Rechtecks aufgebracht. Die erste metallische Paste 19 enthält ein Metall, beispielsweise Kupfer, und einen Glasanteil. Anschließend wird die erste metallische Paste 19 eingebrannt.

Beispielsweise findet der Einbrandschritt bei einer Temperatur von 760 °C in einer N₂-Atmosphäre statt.

Auf die so erhaltene erste Metallisierung 8 wird gemäß Figur 4B zur Ausbildung der zweiten Metallisierung 9 eine zweite metallische Paste 20, beispielsweise in einem Siebdruckverfahren, aufgebracht. Die zweite metallische Paste 8 ist U-förmig ausgebildet. Die zweite metallische Paste 8 enthält ein Metall, beispielsweise Kupfer, aber keinen Glasanteil. Anschließend wird die zweite metallische Paste 20 eingebrannt. Beispielsweise findet der Einbrandschritt ebenfalls bei 760 °C statt.

Auf die erhaltene zweite Metallisierung 9 werden optional eine oder mehrere weitere, dünne metallische Schichten aufgebracht. Diese Schichten können zum Schutz der zweiten Metallisierung 9, insbesondere bei einer Kupfer aufweisenden zweiten Metallisierung 9, ausgebildet sein. Beispielsweise werden die Schichten aufgesputtert. Beispielsweise kann eine Kupferschicht und darüber eine Silberschicht auf die zweite Metallisierung 9 aufgebracht werden. Die Kupferschicht ist beispielsweise 0,3 µm dick und die Silberschicht 0,4 µm dick. Die Silberschicht löst sich vorzugsweise in einem Lotmaterial. Durch Aufbringen der weiteren Schichten kann die Lötbarkeit der zweiten Metallisierung 9 verbessert werden.

Gemäß Figur 4C wird anschießend ein Kontaktelement 14 oberhalb der ersten und zweiten Metallisierung 8, 9 angeordnet. Das Kontaktelement 14 ist beispielsweise als Drahtgewebe ausgebildet. Das Kontaktelement 14 kann bereits vor dem Anordnen am Grundkörper 2 mit einem Lotmaterial versehen sein. Beispielsweise ist das Kontaktelement 14 mit dem Lotmaterial galvanisiert. Insbesondere kann das Kontaktelement 14 auf seiner gesamten, dem Grundkörper 2 zugewandten Oberfläche mit Lotmaterial versehen sein. Durch Erwärmen des Lotmaterials wird nun eine Verbindung des Kontaktelements 14 mit der zweiten Metallisierung 9 hergestellt. Aufgrund der guten Benetzbarkeit der zweiten Metallisierung 9 wird das Kontaktelement 14 fest mit der zweiten Metallisierung 9 verbunden. Somit entsteht am Ort der zweiten Metallisierung ein Befestigungsbereich 15 des Kontaktelements 14 9. Aufgrund der schlechten Benetzbarkeit der ersten Metallisierung 9 mit dem Lotmaterial wird das Kontaktelement 14 nicht oder nur mit geringer Haftfestigkeit mit der ersten Metallisierung 8 verbunden. Somit entsteht ein Bereich geringer Haftfestigkeit 16 in einem Bereich oberhalb der ersten Metallisierung 8, der nicht von der zweiten Metallisierung 9 bedeckt ist.

Bei der Verlötung des Kontaktelements 14 wird das Kontaktelement 14 vorzugsweise an den Grundkörper 2 angepresst. Dadurch, dass die zweite Metallisierung 9 auf der ersten Metallisierung 8 angeordnet ist und somit eine Stufe zwischen der ersten und zweiten Metallisierung 8, 9 ausgebildet ist, ist der Anpressdruck auf der zweiten Metallisierung 9 höher als auf der ersten Metallisierung 8. Durch den unterschiedlichen Anpressdruck wird die unterschiedliche Haftfestigkeit des Kontaktelements auf der zweiten Metallisierung 9 zusätzlich unterstützt.

Die äußere geometrische Abmessung des Kontaktelements 14 ist vorzugsweise etwas geringer als die äußere Abmessung der zweiten Metallisierung 9. Somit steht das Kontaktelement 14 nicht über die zweite Metallisierung 9 seitlich über. Insbesondere sind seitliche Randbereiche des Kontaktelements 14 mit der zweiten Metallisierung 9 verlötet. Auf diese Weise kann die Zuverlässigkeit des Bauelements 1 erhöht werden. Insbesondere kann verhindert werden, dass überstehende Bereiche des Kontaktelements 14 beschädigt werden, zur Ablösung des Kontaktelements 14 führen oder zu einem Kurzschluss führen.

Gemäß Figur 4D kann optional eine Weiterkontaktierung 18 am Außenkontakt 7 befestigt werden. Die Weiterkontaktierung 18 kann als Kontaktstift ausgebildet sein. Die Weiterkontaktierung 18 wird auf das Kontaktelement 14 aufgelegt und beispielsweise mit dem Kontaktelement 14 verschweißt.

Die Weiterkontaktierung 18 erstreckt sich über die Öffnung 17 der zweiten Metallisierung 9 in einen mittigen Bereich oberhalb der U-förmigen zweiten Metallisierung 9 hinein. Bei einer derartigen Anordnung der Weiterkontaktierung 18 kann die Weiterkontaktierung 18 besonders zuverlässig an dem Kontaktelement 16 befestigt werden. Bei dem Schweißvorgang kann die Weiterkontaktierung 18 an das Kontaktelement 14 angedrückt werden, wobei durch die Nachgiebigkeit des Kontaktelements 14 im Bereich geringer Haftfestigkeit 16 ein guter Kontakt zwischen der Weiterkontaktierung 18 und dem Kontaktelement 14 hergestellt werden kann. Weiterhin ist bei einer Anordnung der Weiterkontaktierung 18 derart, dass der Kontaktstift nicht oberhalb der zweiten Metallisierung 9 angeordnet ist, die Gefahr einer Beschädigung des Außenkontakts 7 beim Schweißvorgang verringert. Darüber hinaus beeinträchtigt eine derart angeordnete Weiterkontaktierung 18 eine Ausdehnung des Bauelements 1 nicht oder nur wenig.

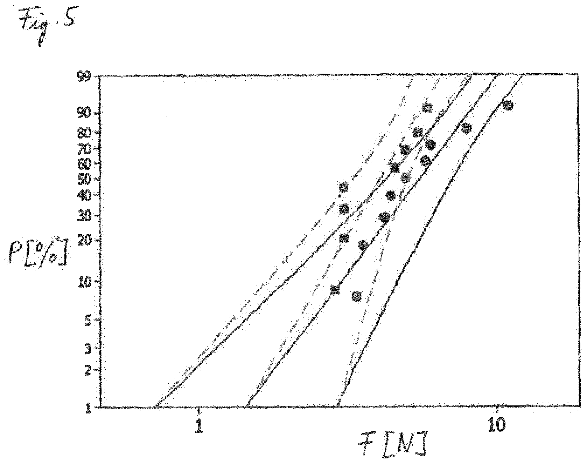

Figur 5 zeigt ein Diagramm, in dem die Häufigkeit P eines Abzugs verschiedener Außenkontakte gegen eine ausgeübte Kraft F dargestellt ist. Unter einen Abzug eines Außenkontakts fällt beispielsweise ein Riss einer Weiterkontaktierung, eine partielle Ablösung einer Metallisierung oder eine Ablösung der Weiterkontaktierung von der Metallisierung.

Für den Abzugstest wurde ein Bauelement 1 gemäß Figur 3 aufweisend eine Weiterkontaktierung 18 in Form eines Drahtgewebes bereitgestellt. Im Kopfbereich wurde die zweite Metallisierung 9 mit Kaptonfolie abgeklebt, so dass in diesem Bereich die Weiterkontaktierung 18 nicht mit der zweiten Metallisierung 9 verlötet wurde. Anschließend wurde an das nicht verlötete Stück der Weiterkontaktierung 18 beim Abzugstest unter Ausübung verschiedener Kräfte angegriffen. Die Geschwindigkeit beim Abziehen betrug 12,5 mm/min.

Zum Vergleich wurde derselbe Test mit einem Bauelement 1 durchgeführt, bei dem die erste Metallisierung 8 U-förmig ausgebildet ist, also nicht wie bei dem in Figur 3 gezeigten Bauelement 1 vollflächig in Form eines Rechtecks ausgebildet ist Die Messwerte für eine vollflächige erste Metallisierung 8 sind durch kreisförmige Symbole dargestellt. Darüber hinaus ist an die Messwerte eine Weibull-Verteilung angepasst, die durch gestrichelte Linien dargestellt ist. Die Messwerte für eine U-förmige erste Metallisierung 8 sind durch die rechteckigen Symbole dargestellt. Auch hier ist eine Weibull-Verteilung angepasst, die durch durchgezogene Linien dargestellt ist.

Insgesamt lässt sich aus dem Diagramm ablesen, dass bei einer vollflächig aufgebrachten ersten Metallisierung 8 die Abzugskräfte um ca. 40 % gegenüber einer U-förmig aufgebrachten ersten Metallisierung erhöht sind. Der Mittelwert für die Abzugskraft lag bei einer vollflächigen ersten Metallisierung 8 bei 5,7 N mit einer Standardabweichung von 2,4 N. Bei einer Kraft F von 5,6 N war in 50 % und bei einer Kraft von 8,2 N war in 90 % der Fälle der Außenkontakt 7 abgezogen. Der Mittelwert für die Abzugskraft lag bei einer U-förmigen ersten Metallisierung 8 bei 4,1 N mit einer Standardabweichung von 1,2 N. Bei einer Kraft F von 4,1 N war in 50 % und bei einer Kraft von 5,6 N war in 90 % der Fälle der Außenkontakt 7 abgezogen.

### Bezugszeichenliste

- 1: elektrisches Bauelement
- 2: Grundkörper
- 3: erste Innenelektrode
- 4: zweite Innenelektrode
- 5: dielektrische Schicht
- 6: Außenseite
- 7: Außenkontakt
- 8: erste Metallisierung
- 9: zweite Metallisierung
- 10: erster Teilbereich
- 11: zweiter Teilbereich
- 12: Aussparung in zweiter Metallisierung
- 13: dritter Teilbereich
- 14: Kontaktelement
- 15: Befestigungsbereich
- 16: Bereich geringer Haftfestigkeit
- 17: Öffnung
- 18: Weiterkontaktierung
- 19: erste metallische Paste
- 20: zweite metallische Paste

- S: Stapelrichtung
- d₁: Dicke der ersten Metallisierung
- d₂: Dicke der zweiten Metallisierung
- P: Häufigkeit eines Abzugs eines Außenkontakts
- F: Kraft

## Patentansprüche

1. Elektrisches Bauelement (1), das als Vielschichtbauelement aufweisend funktionale Schichten (5) und dazwischen liegende Innenelektroden (3, 4) ausgebildet ist, mit wenigstens einem Außenkontakt (7) aufweisend eine erste Metallisierung (8) und eine zweite Metallisierung (9), die auf der ersten Metallisierung (8) angeordnet ist, wobei die erste und die zweite Metallisierung (8, 9) eingebrannt sind, wobei die zweite Metallisierung (9) die erste Metallisierung (8) nur teilweise bedeckt,
**dadurch gekennzeichnet, dass** die zweite Metallisierung (9) U-förmig ausgebildet ist.

2. Elektrisches Bauelement nach Anspruch 1, wobei die erste und die zweite Metallisierung (8, 9) eine unterschiedliche Benetzbarkeit mit Lotmaterial aufweisen.

3. Elektrisches Bauelement nach einem der vorhergehenden Ansprüche, bei dem die erste Metallisierung (8) einen Glasanteil aufweist und bei dem die zweite Metallisierung (9) keinen Glasanteil oder einen geringeren Glasanteil als die erste Metallisierung (8) aufweist.

4. Elektrisches Bauelement nach einem der vorhergehenden Ansprüche, bei dem die zweite Metallisierung (9) wenigstens eine Aussparung (12) aufweist.

5. Elektrisches Bauelement nach Anspruch 4, bei dem in der Aussparung (12) die erste Metallisierung (8) zu sehen ist.

6. Elektrisches Bauelement nach einem der vorhergehenden Ansprüche, bei dem die erste Metallisierung (8) vollflächig ausgebildet ist.

7. Elektrisches Bauelement nach einem der vorhergehenden Ansprüche, bei dem an der zweiten Metallisierung (9) ein Kontaktelement (14) befestigt ist.

8. Elektrisches Bauelement nach Anspruch 7, bei dem das Kontaktelement (14) angelötet ist.

9. Elektrisches Bauelement nach einem der Ansprüche 7 oder 8, wobei das Kontaktelement (14) eine Gewebestruktur aufweist.

10. Elektrisches Bauelement nach einem der Ansprüche 7 bis 9, aufweisend eine Weiterkontaktierung (18), die an dem Kontaktelement (14) befestigt ist.

11. Elektrisches Bauelement nach Anspruch 10, wobei die Weiterkontaktierung (18) nicht oberhalb der zweiten Metallisierung (9) angeordnet ist.

12. Elektrisches Bauelement nach einem der Ansprüche 10 oder 11, bei dem sich die Weiterkontaktierung (18) oberhalb einer Öffnung (17) der U-Form in das Innere der U-Form hinein erstreckt.

13. Elektrisches Bauelement nach einem der Ansprüche 10 bis 12, bei dem die Weiterkontaktierung (18) als Kontaktstift ausgebildet ist.

14. Elektrisches Bauelement nach einem der vorhergehenden Ansprüche, das als Piezoaktor ausgebildet ist.

15. Verfahren zur Herstellung einer elektrischen Kontaktierung eines elektrischen Bauelements nach einem der vorhergehenden Ansprüche, aufweisend die Schritte
A) Bereitstellen eines Grundkörpers (2) des elektrischen Bauelements (1) und Aufbringen einer ersten metallischen Paste (19) auf einer Außenseite (6) des Grundkörpers (2),
B) Einbrennen der ersten metallischen Paste (19) zur Ausbildung der ersten Metallisierung (8),
C) Aufbringen einer zweiten metallischen Paste (20) auf die erste Metallisierung (8),
D) Einbrennen der zweiten metallischen Paste (20) zur Ausbildung der zweiten Metallisierung (9).

## Claims

1. Electrical component (1), which is embodied as a multilayer component having functional layers (5) and internal electrodes (3, 4) lying therebetween, comprising at least one external contact (7) having a first metallization (8) and a second metallization (9), which is arranged on the first metallization (8), wherein the first and second metallizations (8, 9) are fired, wherein the second metallization (9) only partly covers the first metallization (8), **characterized in that** the second metallization (9) is embodied in a U-shaped fashion.

2. Electrical component according to Claim 1, wherein the first and second electrical components (8, 9) have a different wettability with solder material.

3. Electrical component according to either of the preceding claims, wherein the first metallization (8) has a glass portion and wherein the second metallization (9) has no glass portion or a smaller glass portion than the first metallization (8).

4. Electrical component according to any of the preceding claims, wherein the second metallization (9) has at least one cutout (12).

5. Electrical component according to Claim 4, wherein the first metallization (8) can be seen in the cutout (12) .

6. Electrical component according to any of the preceding claims, wherein the first metallization (8) is embodied over the whole area.

7. Electrical component according to any of the preceding claims, wherein a contact element (14) is fixed to the second metallization (9).

8. Electrical component according to Claim 7, wherein the contact element (14) is soldered.

9. Electrical component according to either of Claims 7 and 8, wherein the contact element (14) has a fabric structure.

10. Electrical component according to any of Claims 7 to 9, having a further contact-connection (18), which is fixed to the contact element (14).

11. Electrical component according to Claim 10, wherein the further contact-connection (18) is not arranged above the second metallization (9).

12. Electrical component according to either of Claims 10 and 11, wherein the further contact-connection (18) extends above an opening (17) of the U-shape into the interior of the U-shape.

13. Electrical component according to any of Claims 10 to 12, wherein the further contact-connection (18) is embodied as a contact pin.

14. Electrical component according to one of the preceding claims, which is embodied as a piezoactuator.

15. Method for establishing electrical contact with an electrical component according to any of the preceding claims, having the steps of
A) providing a main body (2) of the electrical component (1) and applying a first metallic paste (19) on an outer side (6) of the main body (2),
B) firing the first metallic paste (19) to form the first metallization (8),
C) applying a second metallic paste (20) to the first metallization (8),
D) firing the second metallic paste (20) to form the second metallization (9).

## Revendications

1. Composant électrique (1), réalisé sous la forme d'un composant multicouche comportant des couches fonctionnelles (5) et des électrodes intérieures (3, 4) disposées entre celles-ci, comportant au moins un contact extérieur (7) présentant une première métallisation (8) et une deuxième métallisation (9), qui est disposée sur la première métallisation (8), dans lequel les première et deuxième métallisations (8, 9) sont cuites, dans lequel la deuxième métallisation (9) ne recouvre qu'en partie la première métallisation (8),
**caractérisé en ce que** la deuxième métallisation (9) est réalisée en forme de U.

2. Composant électrique selon la revendication 1, dans lequel les première et deuxième métallisations (8, 9) présentent des mouillabilités différentes avec un matériau de brasage.

3. Composant électrique selon l'une des revendications précédentes, dans lequel la première métallisation (8) présente une fraction de verre et dans lequel la deuxième métallisation (9) ne présente aucune fraction de verre ou présente une fraction de verre inférieure à celle de la première métallisation (8) .

4. Composant électrique selon l'une des revendications précédentes, dans lequel la deuxième métallisation (9) présente au moins un évidement (12).

5. Composant électrique selon la revendication 4, dans lequel la première métallisation (8) se trouve dans l'évidement (12).

6. Composant électrique selon l'une des revendications précédentes, dans lequel la première métallisation (8) est réalisée de manière à s'étendre sur la totalité de la surface.

7. Composant électrique selon l'une des revendications précédentes, dans lequel un élément de contact (14) est fixé à la deuxième métallisation (9).

8. Composant électrique selon la revendication 7, dans lequel l'élément de contact (14) est brasé.

9. Composant électrique selon l'une des revendications 7 ou 8, dans lequel l'élément de contact (14) présente une structure de tissu.

10. Composant électrique selon l'une des revendications 7 à 9, comportant un prolongateur de contact (18) qui est fixé à l'élément de contact (14).

11. Composant électrique selon la revendication 10, dans lequel le prolongateur de contact (18) n'est pas disposé au-dessus de la deuxième métallisation (9).

12. Composant électrique selon l'une des revendications 10 ou 11, dans lequel le prolongement de contact (18) s'étend au-dessus d'une ouverture (17) de la forme en U à l'intérieur de la forme en U.

13. Composant électrique selon l'une des revendications 10 à 12, dans lequel le prolongement de contact (18) est réalisé sous la forme d'une broche de contact.

14. Composant électrique selon l'une des revendications précédentes, qui est réalisé sous la forme d'un actionneur piézoélectrique.

15. Procédé d'établissement d'un contact électrique d'un composant électrique selon l'une des revendications précédentes, comportant les étapes consistant à :
A) fournir un corps de base (2) du composant électrique (1) et déposer une première pâte métallique (19) sur une face extérieure (6) du corps de base (2),
B) cuire la première pâte métallique (19) pour former la première métallisation (8),
C) déposer une deuxième pâte métallique (20) sur la première métallisation (8),
D) cuire la deuxième pâte métallique (20) pour former la deuxième métallisation (9).
